# EUROPEAN PATENT APPLICATION

(11) **EP 2 874 475 A1**
(43) Date of publication of application: **20.05.2015**
(21) Application number: 14190182.7
(22) Date of filing: 23.10.2014
(51) Int. Cl.: H05K 1/05, H05K 3/00

(54) **Surface preparation using optical energy**

(30) Priority: 19.11.2013 US 201314083919
(71) Applicant: Sensata Technologies, Inc., Attleboro, MA 02703 (US)
(72) Inventor: Johnson, Steven E., Attleboro, Massachusetts 02703 (US); St. Pierre, Keith, Somerset, Massachusetts 02726 (US); Breault, Eric, Rehoboth, Massachusetts 02769 (US)
(74) Representative: Legg, Cyrus James Grahame

(57) **Abstract**

A fabrication resource receives a base material such as metal or other suitable material. The fabrication resource applies optical energy to a surface of the base material. Application of the optical energy transforms a texture on the surface of the base material. Subsequent to transforming the texture on the surface of the base material, the fabrication resource then adheres a supplemental material such as paste including glass powder to the transformed texture on the surface. Application of heat to the paste fuses the glass powder of the applied paste into a glass layer that adheres to the transformed texture. The fabrication resource contacts an electronic circuit device onto an exposed facing of the glass layer and reheats the combination of the electronic circuit device, glass layer, and base material. The application of heat secures the electronic circuit device to the layer of glass and corresponding base material.

## Description

### BACKGROUND

Conventional techniques of processing a surface can include sandblasting. In general, sandblasting is an abrasive operation in which sand (or other suitable material such as glass) is physically propelled at a high speed onto a surface. The target material to be sandblasted can be metal, wood, plastic, etc.

Typically, the purpose of sandblasting is to remove undesirable material from a respective surface. However, sandblasting can be performed for other reasons as well. For example, sandblasting can be performed to smooth a rough surface, roughen a smooth surface, shape a surface, etc.

During conventional sandblasting, a pressurized fluid such as air is typically used to propel the media towards the target surface. The force of the propelled media striking the target surface removes undesirable material. In certain instances, as mentioned, if the media is propelled at a substantially high velocity against a target object, the texture of the target object will be modified.

### BRIEF DESCRIPTION

Conventional techniques of modifying a surface on a target object such as via sandblasting suffer from a number of deficiencies. For example, the media used to sandblast a surface can include contaminants, which sometimes adhere to the surface of the target object. Additionally, part of the sandblast media (possibly considered to be a contaminant) itself can adhere to crevices on the surface as formed by the sandblasting process. To remove the contaminants such as embedded sandblast media, the surface of the target object has to be cleaned. In certain instances, this is very difficult.

Moreover, it is typically difficult to precisely control which portion on the surface of the target object is to be sandblasted because the propulsion of sandblast media is somewhat random and difficult to control. For this reason, a roughness of the surface of the target object can vary substantially when sandblasting.

In contrast to conventional techniques, embodiments herein include a fabrication resource that is configured to produce a circuit assembly.

In one embodiment, the fabrication resource receives a base material such as metal or other suitable material. The base material can include a surface to be prepared by the fabrication resource. To prepare a surface, the fabrication resource applies optical energy to a surface of the base material. Application of the optical energy transforms a texture on the surface of the base material. Subsequent to transforming the texture on the surface of the base material, the fabrication resource then adheres a supplemental material such as glass or other suitable material to the transformed surface texture of the base material.

In accordance with further embodiments, adhering the supplemental material to the transformed texture on the surface of the base material can include: i) applying a paste to the transformed texture, the paste can include glass powder; and ii) applying heat to the paste disposed on the transformed surface texture, application of the heat fusing molten glass into a glass layer that adheres to the transformed texture; and iii) cooling the base material and glass layer.

Thereafter, the fabrication resource can be configured to adhere a device (or any suitable material) such as an electronic circuit device onto an exposed facing of the glass layer. As an example, adhering the electronic circuit device (an integrated circuit device) onto the exposed facing of the glass layer can include: i) contacting the electronic circuit device to the exposed facing of the glass layer, and ii) applying heat to a combination of the electronic circuit device, glass layer, and base material. The application of heat secures the electronic circuit device to the layer of glass.

Accordingly, embodiments herein can include fabricating an assembly. The assembly can be a multilayer be a multilayer assembly including: a base material, a surface texture of which is transformed via application of optical energy, a supplemental layer of material such as glass, and a circuit device. The supplemental material such as insulation material adheres to the transformed texture on the surface. The electronic circuit device adheres to an exposed facing of the glass layer opposite a facing of the glass layer adhered to the transformed surface texture.

In accordance with further embodiments herein, a fabrication resource can be configured to receive boundary location information defining a region on the surface of the base material. In other words, the boundary location information indicates a portion of the surface on base material that is to be prepared. The fabrication and assembly applies a sequence of optical pulses to specified locations such as within the boundaries as specified by the boundary location information. By way of non-limiting example, in one embodiment, the boundaries as specified by boundary location information define a contiguous region in which to produce the transformed texture (i.e., modified surface).

In yet further embodiments, the method of fabrication can include application of the sequence of optical pulses. Application of the sequence of optical pulses can include: applying a first optical pulse to a first location within the contiguous region, the first optical pulse creating a first surface modification such as a depression in the contiguous region; applying a second optical pulse to a second location within the contiguous region, the second optical pulse creating a second surface modification such as a depression in the contiguous region; applying a third optical pulse to a third location within the contiguous region, the third optical pulse creating a third surface modification such as a depression in the contiguous region; applying a fourth optical pulse to a fourth location within the contiguous region, the fourth optical pulse creating a fourth surface modification such as a depression in the contiguous region; and so on.

In comparison to an initial state in which a corresponding surface of the base material is smooth, the surface modifications (as produced by application of the optical energy) roughen the surface of the base material.

The surface modifications such as depressions formed by the optical pulses can overlap each other. For example, the second depression can at least partially overlap with the first depression; the third depression can at least partially overlap with the second depression; the fourth depression can at least partially overlap with the third depression; and so on.

The pattern of modifications such as depressions on the surface of the base material can be formed in any suitable manner. For example, in one embodiment, the fabrication resource scans a laser beam across the surface of the base material. The laser beam conveys a sequence of optical pulses (each pulse being a burst of optical energy) within the boundaries of the contiguous region to produce the transformed texture.

As discussed herein, the texture of the surface in the contiguous region can vary depending upon an amount of optical energy applied to the corresponding surface of the base material. Application of a higher optical energy to the surface typically results in a deeper depression (more substantial modification) and rougher surface. Application of lower optical energy to the surface of base material typically results in a more shallow depression (less substantial modification) and less rough surface.

The pattern of modifications on the surface of the base material can be formed via a single pass or multipass application of optical energy. For example, in one embodiment, the fabrication resource can be configured to first scan a generated laser beam in a first direction across the surface of the base material. This can be repeated in a raster manner to modify an entire region.

If further modification of the respective surface is desired, the fabrication resource then scans the laser beam in a second direction across the surface of the base material. In one embodiment, the second direction is substantially nonparallel with respect to the first direction. Embodiments herein can include scanning in any number of directions. Accordingly, embodiments herein can include producing the transformed texture to be a cross hatched pattern of overlapping surface modifications produced by the optical energy.

Embodiments herein are beneficial over conventional techniques of sandblasting a respective surface to transform a texture of the surface. For example, first, because optical energy is used to modify the respective surface, there are no contaminants deposited on the surface. Thus, no contaminants are trapped between the glass layer and the surface of the base material. Second, the optical energy can be precisely directed to a particular region of interest on the target object. This reduces an amount of wasted surface area or usable space on a surface of the target object. Third, the optical energy can be precisely controlled to produce a desired amount of roughness on the surface of the object. Additional benefits are discussed below.

Further, the present invention provides a method comprising:
receiving a base material;
applying optical energy to a surface of the base material, application of the optical energy transforming a texture on the surface of the base material; and
adhering a supplemental material to the transformed texture on the surface.

The adhering the supplemental material to the transformed texture on the surface may include: i) applying a paste to the transformed texture, the paste including glass powder; and ii) applying heat to the paste, application of the heat fusing the glass powder of the applied paste into a glass layer adhering to the transformed texture; and iii) cooling the base material and glass layer; and adhering an electronic circuit device onto an exposed facing of the glass layer.

The heat applied to the paste may convert the glass powder into molten glass; and the transformed surface texture may substantially prevents flow of the molten glass along the surface of the base material.

The adhering the electronic circuit device onto the exposed facing of the glass layer may include: i) contacting the electronic circuit device to the exposed facing of the glass layer, and ii) applying heat to a combination of the electronic circuit device, glass layer, and base material.

The applying the optical energy to the surface of the base material may include:
receiving boundary location information defining a contiguous region on the surface of the base material; and
applying a sequence of optical pulses within boundaries as specified by the boundary location information, the boundaries defining the contiguous region.

The applying the sequence of optical pulses may include:
applying a first optical pulse to a first location within the contiguous region, the first optical pulse creating a first depression in the contiguous region;
applying a second optical pulse to a second location within the contiguous region, the second optical pulse creating a second depression in the contiguous region, the second depression at least partially overlapping with the first depression.

The applying the optical energy may include:
scanning a laser beam across the surface of the base material, the laser beam conveying a sequence of optical pulses to produce the transformed texture.

The applying the optical energy may include:
scanning a laser beam in a first direction across the surface of the base material; and
scanning the laser beam in a second direction across the surface of the base material, the second direction substantially nonparallel with respect to the first direction.

The heat applied to the paste may convert the glass powder into molten glass; and the transformed surface texture may allow flow of the molten glass along the surface of the base material.

The adhering the supplemental material to the transformed texture on the surface may include: i) applying a paste to the transformed texture in the contiguous region defined by the boundary location information, the paste including glass powder; and ii) applying heat to the paste, application of the heat fusing the glass powder into a glass layer adhered to the transformed texture in the contiguous region; and iii) cooling the base material and glass layer;
contacting an electronic circuit device to the exposed facing of the glass layer; and applying heat to a combination of the electronic circuit device, glass layer, and base material.

The present invention also provides an assembly comprising:
a base material;
a texture on a surface of the base material transformed via application of optical energy; and
supplemental material adhered to the transformed texture on the surface.

The supplemental material adhered to the transformed texture on the surface may be a paste applied to the transformed texture, the paste including glass powder, application of heat to the paste fusing the glass powder of the applied paste into a glass layer adhering to the transformed texture.

The assembly may comprise:
an electronic circuit device adhered onto an exposed facing of the glass layer, the exposed facing opposite a facing of the glass layer adhered to the transformed texture.

The electronic circuit device may be an integrated circuit device; and the base material may be made of metal material.

The transformed texture may reside within a contiguous region on the surface of the base material, the contiguous region defined by boundary location information.

The transformed texture in the contiguous region may include:
a first optically-generated depression in a first location within the contiguous region; and
a second optically-generated depression in second location within the contiguous region, the second optically-generated depression overlapping with the first optically-generated depression.

The transformed texture on the surface of the base material may include a pattern of optically-generated surface modifications.

The pattern of optically-generated surface modifications on the transformed texture may include:
a first sequence of optically-generated modifications disposed in a first direction across the surface of the base material; and
a second sequence of optically-generated modifications disposed in a second direction across the surface of the base material, the second direction being substantially nonparallel with respect to the first direction.

The transformed texture may be a cross hatched pattern of overlapping optically-generated surface modifications.

The invention further provides a system to produce the assembly, the system including:
an optical energy source that produces the optical energy; and
a optical steering assembly, the optical steering assembly steering the optical energy to the surface of the base material.

These and other embodiment variations are discussed in more detail below.

As mentioned above, note that embodiments herein can include a configuration of one or more computerized devices, hardware processor devices, assemblers, fabrication resources, or the like to carry out and/or support any or all of the method operations disclosed herein. In other words, one or more computerized devices, processors, digital signal processors, assemblers, etc., can be programmed and/or configured to perform the method as discussed herein.

Additionally, although each of the different features, techniques, configurations, etc., herein may be discussed in different places of this disclosure, it is intended that each of the concepts can be executed independently of each other or in combination with each other. Accordingly, the one or more present inventions, embodiments, etc., as described herein can be embodied and viewed in many different ways.

Also, note that this preliminary discussion of embodiments herein does not specify every embodiment and/or incrementally novel aspect of the present disclosure or claimed invention(s). Instead, this brief description only presents general embodiments and corresponding points of novelty over conventional techniques. For additional details and/or possible perspectives (permutations) of the invention(s), the reader is directed to the Detailed Description section and corresponding figures of the present disclosure as further discussed below.

### BRIEF DESCRIPTION OF THE DRAWINGS

FIG. 1 is an example diagram of a fabrication resource configured to produce and assembly according to embodiments herein.
FIG. 2 is an example perspective view illustrating transformation of a surface texture according to embodiments herein.
FIG. 3 is an example top view diagram illustrating a single pass preparation of a surface on a base material according to embodiments herein.
FIG. 4 is an example top view diagram illustrating a multiple pass preparation of a surface on a base material according to embodiments herein.
FIG. 5A is an example side view diagram illustrating surface preparation according to conventional techniques.
FIG. 5B is an example side view diagram illustrating surface preparation according to embodiments herein.
FIG. 6 is an example top view diagram illustrating a transformed surface texture according to embodiments herein.
FIG. 7A is an example side view diagram illustrating application of a layer of a paste material and subsequent application of heat according to embodiments.
FIG. 7B is an example side view diagram illustrating a layer of material disposed on transformed surface texture according to embodiments herein.
FIG. 7C is an example side view diagram illustrating mounting of a device onto a layer of material disposed a substrate according to embodiments herein.
FIG. 8A is an example side view diagram illustrating application of a layer of a paste material and subsequent application of heat according to embodiments.
FIG. 8B is an example side view diagram illustrating the flow of a layer of material disposed on transformed surface texture according to embodiments herein.
FIG. 8C is an example side view diagram illustrating mounting of a device onto a layer of material disposed a substrate according to embodiments herein.
FIG. 9 is an example diagram illustrating a method of fabricating an assembly according to embodiments herein.

The foregoing and other objects, features, and advantages of the invention will be apparent from the following more particular description of preferred embodiments herein, as illustrated in the accompanying drawings in which like reference characters refer to the same parts throughout the different views. The drawings are not necessarily to scale, with emphasis instead being placed upon illustrating the embodiments, principles, concepts, etc.

### DETAILED DESCRIPTION

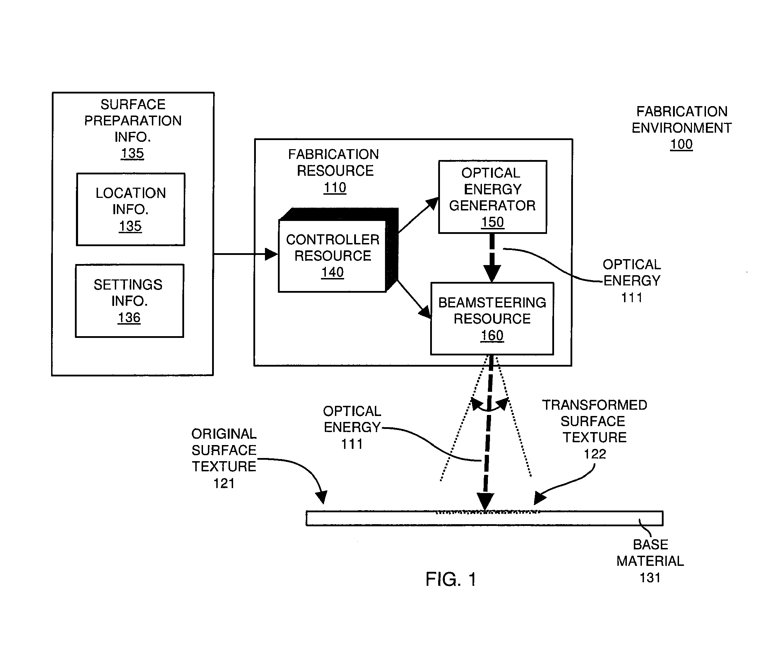

FIG. 1 is an example diagram of a fabrication environment in which to transform a surface texture on base material according to embodiments herein.

As shown, fabrication environment 100 includes fabrication resource 110. Fabrication resource 110 includes control resource 140, optical energy generator 150, and beam steering resource 160. As its name suggests, the control resource 140 controls optical energy generator 150 and beam steering resource 160.

By way of non-limiting example, in one embodiment, the optical energy generator 150 is a laser device configured to generate optical energy 111 such as a laser beam. The beam steering resource 160 can include one or more mirrors. The controller resource 140 controls an orientation of the mirrors to steer the received optical energy 111 in any suitable manner towards base material in 131.

Via application and steering of the optical energy 111 to the original surface texture 121 on base material 131, the fabrication resource 110 converts a corresponding portion of the surface of base material 131 into transformed surface texture 122. A degree of roughness associated with the transformed surface texture 122 can vary depending upon settings such as a power level of optical energy applied to corresponding locations on base material 131.

Multiple parameters of the optical energy generator 150 can be controlled to produce transformed surface texture 122 on base material 131. For example, the rate of sweeping optical energy 111 across the surface of base material 131 can be controlled; a magnitude of the frequency of pulses in optical energy 111 can be controlled; and so on.

Base material 131 can be any suitable material such as metal, plastic, etc. base material 131 may be received in any suitable form. As shown, a top surface to which the optical energy 111 is applied can be substantially planar.

In accordance with further embodiments herein, the controller resource 140 in fabrication resource 110 can be configured to receive surface preparation information 132 indicating how to prepare a corresponding surface of base material 131.

Surface preparation information 132 can include settings information 136. In one embodiment, the settings information 136 indicates settings associated with optical energy generator 150. Via settings information 136, the controller resource 140 can be informed how to control optical energy generator 150 such that the optical energy generator 150 produces optical energy 111 at a desired power level, pulse frequency, etc.

Surface preparation information 132 can also include location information 135. In one embodiment, location information 135 indicates which region or locations on base material 131 to apply corresponding generated optical energy 111. By way of non-limiting example, in one embodiment, the location information 135 can define a contiguous region on the surface of the base material 131 in which to apply optical energy 111.

Thus, in one embodiment, the fabrication resource 110 produces optical energy 111 such as a sequence of optical pulses in accordance with settings information 136. The controller resource 140 uses the location information 135 to steer the sequence of optical pulses to locations on the surface of base material 131 such as within a bounded or contiguous region to produce transformed surface texture 122.

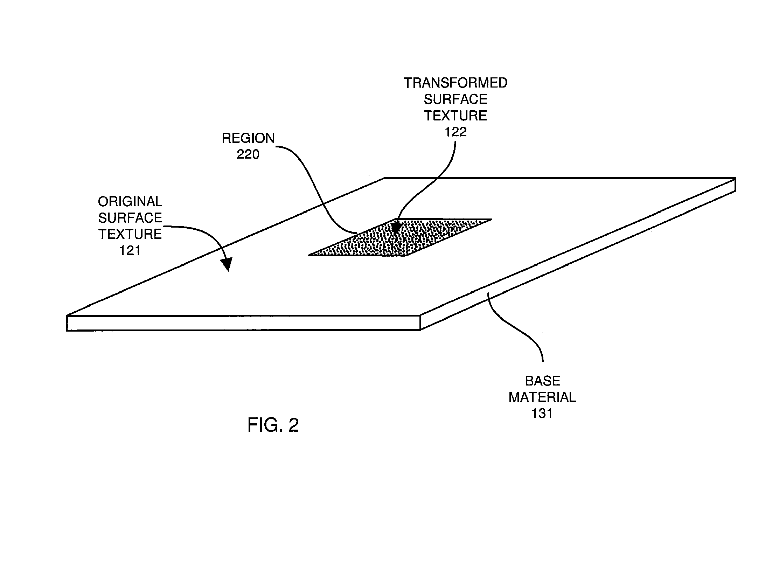

FIG. 2 is an example perspective view illustrating transformation of a surface texture according to embodiments herein.

As shown, a region 220 on top surface of base material 131 includes transformed surface texture 122. Original surface texture 121 on surface of base material 131 can be substantially smooth (i.e., a low degree of roughness). In comparison to the original surface texture 121, transformed surface texture 122 as produced via application of optical energy 111 on region 220 has a higher degree of roughness.

A degree of roughness associated with transformed surface texture 122 can vary depending upon the embodiment. For example, the region 220 on-base material 131 can be substantially rougher by producing a higher level of optical energy 111. Lower levels of optical energy 111 will produce a less rough surface texture. As previously discussed, settings information 136 can indicate and/or control a degree of roughness associated with transformed surface texture 122.

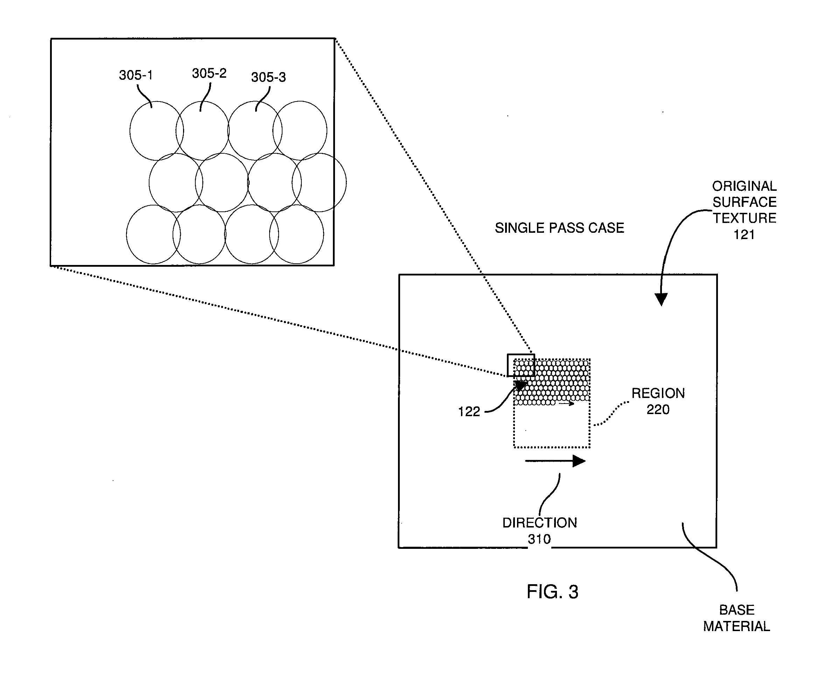

FIG. 3 is an example top view diagram illustrating a single pass preparation of a surface on a base material according to embodiments herein.

The pattern of modifications such as depressions, craters, spots, etc., on the surface of the base material can be formed via a single pass or multi-pass application of optical energy.

By way of non-limiting example, in the single pass application as shown FIG. 3, the fabrication resource 110 can be configured to first scan a generated beam of optical energy 111 such as a sequence of optical pulses in a direction 310 across the surface of the base material 131 to modify the original surface texture 121 and produce transformed surface texture 122.

Scanning of the optical energy 111 can include can include: applying a first optical pulse to a first location within the contiguous region 220, the first optical pulse creating a first surface modification 305-1 such as a depression in the contiguous region 220; applying a second optical pulse to a second location within the contiguous region 220, the second optical pulse creating a second surface modification 305-2 such as a depression in the contiguous region 220; applying a third optical pulse to a third location within the contiguous region 220, the third optical pulse creating a third surface modification 305-3 such as a depression in the contiguous region 220; and so on.

The surface modifications 305 such as depressions formed by the optical pulses can overlap each other. For example, the second modification 305-2 can at least partially overlap with the first modification 305-1; the third modification 305-3 can at least partially overlap with the second modification 305-2; and so on.

The process of generating optical energy 111 and steering the optical energy 111 can be repeated in a rasterized manner to modify the texture of base material 131 in the region 220.

Accordingly, in one embodiment, the fabrication resource 110 repeatedly scans optical energy 111 such as a laser beam across the surface of the base material 131. The optical energy 111 conveys a sequence of optical pulses within region 220 to produce the transformed surface texture 122. As previously discussed, a corresponding roughness associated with the transformed surface texture 122 in the contiguous region 220 can vary depending upon an amount of optical energy applied to the corresponding surface of the race material.

This single pass application of optical energy 111 can complete preparation of the surface of base material 131.

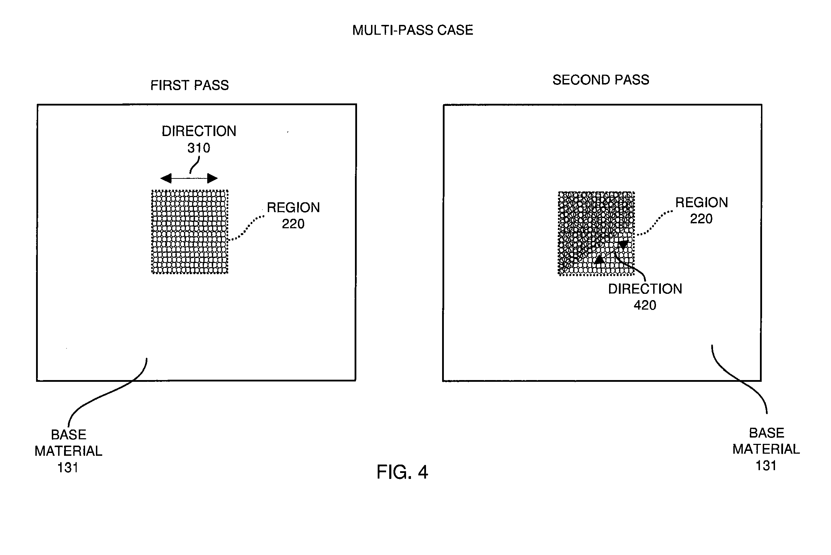

FIG. 4 is an example top view diagram illustrating a multiple pass preparation of a surface on a base material according to embodiments herein.

In accordance with another example embodiment, the fabrication resource 110 can be configured to perform a multi-pass preparation of the surface of base material 131 as opposed to a single pass surface preparation as discussed above.

For example, as shown, in a first direction 310, the fabrication resource 110 performs a first pass application of optical energy 111 to region 220 in a manner as previously discussed. Thereafter, on the second pass, the fabrication resource 110 generates and scans a respective beam of optical energy 111 in a second direction 420 across the surface of the base material 131.

By way of non-limiting example, the second direction 420 is substantially nonparallel with respect to the first direction 310. In this way, embodiments herein can include scanning generated optical energy 111 in any number of directions within region 220.

Accordingly, embodiments herein can include producing the transformed texture to be a cross hatched pattern of overlapping surface modifications produced by the optical energy.

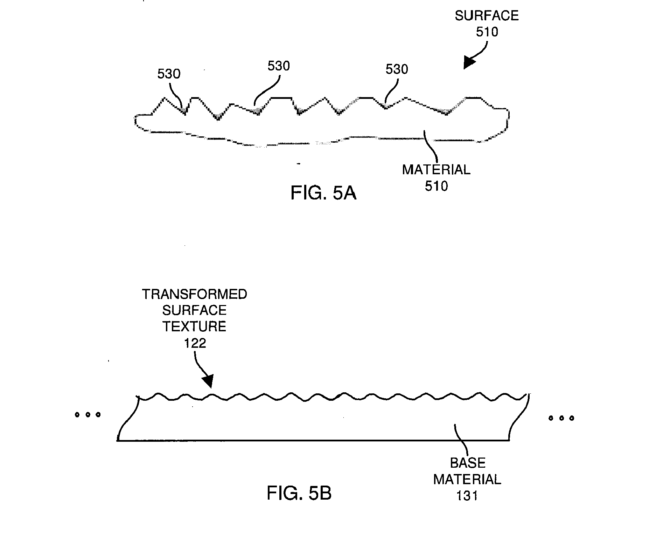

FIG. 5A is an example side view diagram illustrating surface preparation according to conventional techniques.

As shown, and as previously discussed, the surface 505 of material 510 can be modified via sandblasting. Conventional sandblasting modifies surface 505 of material 510. However, conventional sandblasting embeds contaminants 530 into corresponding crevices on surface 505 of material 510.

FIG. 5B is an example side view diagram illustrating surface preparation according to embodiments herein.

Embodiments herein are beneficial over conventional techniques of sandblasting a respective surface 505 to transform a texture of the surface 505.

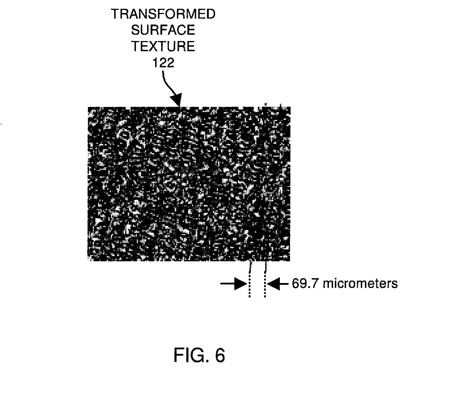

For example, first, because optical energy 111 is used to modify the respective surface of base material 131 to form transformed surface texture 122, there are no contaminants deposited on the surface of base material 131. Thus, no contaminants are trapped between a subsequently applied glass layer and the transformed surface texture 122 of the base material 131. Second, the optical energy 111 can be precisely directed to a particular region of interest on the target object such as base material 131. This reduces an amount of wasted surface area on the target object. Third, the optical energy 111 can be precisely controlled to produce a desired amount of roughness on the surface of the base material 131. FIG. 6 is an example top view pictorial diagram illustrating a transformed surface texture according to embodiments herein.

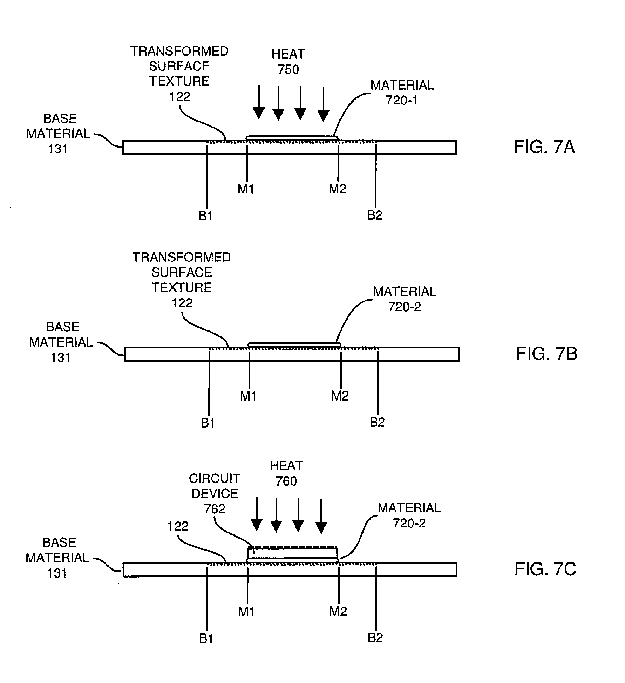

FIG. 7A is an example side view diagram illustrating application of a layer of a paste material and subsequent application of heat according to embodiments.

As previously discussed, the fabrication resource 110 applies optical energy 111 to a surface of the base material 131 to produce transformed surface texture 122. Application of the optical energy 111 transforms a texture on the surface of the base material 131 between boundary B1 and boundary B2.

Subsequent to transforming the texture on the surface of the base material 131, the fabrication resource 110 (or other suitable resource) adheres a layer of supplemental material such as glass or other suitable insulation material to the transformed surface texture 122 of base material 131.

To achieve this end, the fabrication resource 110 applies material 720-1 (i.e., supplemental material) to the transformed surface texture 122 between boundary M1 and boundary M2. By way of non-limiting example, this can include: first applying a material 720-1 such as a paste material to the transformed surface texture 122.

The material 720-1 can be a paste including glass powder. In one embodiment, the paste material (such as material 720-1) is lead free sealing glass paste part number DL11-205 manufactured by Ferro Electronic Materials ™.

The thickness of the applied paste can vary. By way of a non-limiting example, the thickness of paste applied to the laser prepared surface is between 50 and 200 microns, although the thickness can be outside this range if desired. By way of a non-limiting example, where flow out of material is controlled when heating, the thickness of the applied paste is in a range such as between 117 and 167 microns.

The fabrication resource 110 applies heat 750 to the material 720-1. By further way of a non-limiting example, prior to heating, the thickness may be 117 to 167 microns. Application of the heat 750 melts the glass powder to form a layer of material 720-2 (e.g., a layer of insulation material such as glass) as shown in figure 7B. After application of the heat and melting of layer 720-1, in one embodiment, the glass media burns off such that the thickness of layer 720-2 is between 52 and 87 microns.

In one embodiment, as shown, the proper preparation of the transformed surface texture 122 in accordance with surface preparation information 132 prevents flowing of material 720-1 outside of boundary M1 and boundary M2 even after the glass in material 720-1 melts due to application of heat 750.

Note that the optical energy 111 can be controlled such that a roughness of transformed surface texture 122 has a Rz roughness value between 2.5 and 11.0 microns (or any suitable range) depending on whether it is desirable that corresponding layer of material 720 or 820 on base material 131 flows or not when melted.

Roughness values of transformed surface texture 122 allow less flow at the low end of the Rz range (near 3.5) and progressively more flow at the higher end of the Rz range (near 9.5) when paste is melted. In a manner as shown, a surface roughness of transformed surface texture 122 in the lower end of the range near Rz = 4.0 allows relatively little or no flow of layer 720-2 along the surface of base material 131 when melting material 720-1.

FIG. 7B is an example side view diagram illustrating a layer of material disposed on transformed surface texture according to embodiments herein.

After cooling of the base material 131 and layer of material 720-2, and because transformed surface texture 122 has some degree of roughness as a result of surface preparation as previously discussed, the layer of material 720-2 strongly adheres to the transformed surface texture 122. Again, preparation of transformed surface texture 122 prevents flowing of such material along the transformed surface texture 122. More specifically, the resulting layer material 720-2 remains within boundary M1 and boundary M2.

Thus, in one embodiment, the resulting region covered by material 720-2 is substantially the same as the original region of base material 131 on which material 720-1 was applied.

FIG. 7C is an example side view diagram illustrating mounting of a device according to embodiments herein.

Subsequent to adhering layer of material 720-2 to transformed surface texture 122, the fabrication resource 110 mounts a corresponding circuit device 762 onto exposed surface of material 720-2.

In one embodiment, the fabrication resource 110 receives an object such as circuit device 760. The fabrication resource 110 places the circuit device 762 onto an exposed surface of material 720-2. Subsequent to contacting the electronic circuit device 762 to the exposed facing of the glass layer, the fabrication resource 110 applies heat to a combination of the electronic circuit device 762, layer of material 720-2, and base material 131. The application of heat 760 secures a backside of the electronic circuit device 762 to the layer of material 720-2.

Accordingly, the resulting multilayer assembly can include: a layer of base material 131, layer of material 720-2 such as insulation layer, and a corresponding object electronic circuit device 762. As previously discussed, a texture of the surface on the base material 131 is transformed via application of optical energy 111. The layer of material 720-2 adheres to the transformed surface texture 122. The electronic circuit device 762 adheres to the layer of material 720-2.

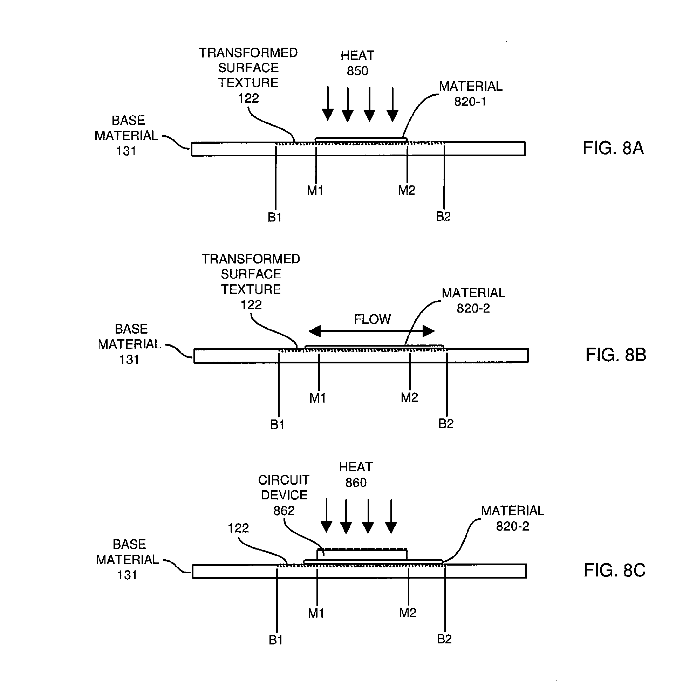

FIG. 8A is an example side view diagram illustrating application of a layer of a paste material and subsequent application of heat according to embodiments.

In this example embodiment, the fabrication resource 110 applies material 820-1 to the transformed surface texture 122 in a region between boundary M1 and boundary M2 as shown. The fabrication resource 110 initiates application of heat 850 to the material 820-1 disposed on transformed surface texture 122.

Assume that the transformed surface texture 122 has a degree of roughness higher than a given threshold value. For example, assume that the roughness of transformed surface texture 122 in FIGS. 8A, 8B, and 8C, is substantially rougher than the transformed surface texture 122 in FIGS. 7A, 7B, and 7C. In such an instance, due to a high degree of roughness associated with transformed surface texture 122, application of heat 850 causes the material 820-1 to melt and flow outside of boundary M1 and boundary M2 as shown in FIG. 8B.

As mentioned, in one embodiment, the optical energy 111 is controlled such that a roughness of transformed surface texture 122 has a roughness Rz value between 2.5 and 11.0 (or any suitable range) depending on whether it is desirable that layer of material 820 on base material 131 flows or not when melted. In a manner as shown, a surface roughness of transformed surface texture 122 in the higher end of the range near Rz = 9.5 allows relatively substantial flow of layer 820-2 along the surface of base material 131 when melting material 820-1.

FIG. 8B is an example side view diagram illustrating the flow of a layer of material disposed on transformed surface texture according to embodiments herein.

As shown, in this example embodiment, while in a molten state, the material 820-2 flows outside of boundary M1 and boundary M2. Accordingly, the degree of roughness associated with the transformed surface texture 122 can be controlled depending upon whether it is desirable that the supplemental material 820-1 in a molten state flow or not flow along a surface of base material 131.

FIG. 8C is an example side view diagram illustrating mounting of a device according to embodiments herein.

In a similar manner as previously discussed, the fabrication resource 110 can receive circuit device and 862. The fabrication resource 110 contacts a backside of the circuit device 862 onto layer of material 820-2. The fabrication resource 110 then applies heat 862 to circuit device 862 and the layer of material 820-2. Application of heat 860 affixes the circuit device 862 to material 820-2.

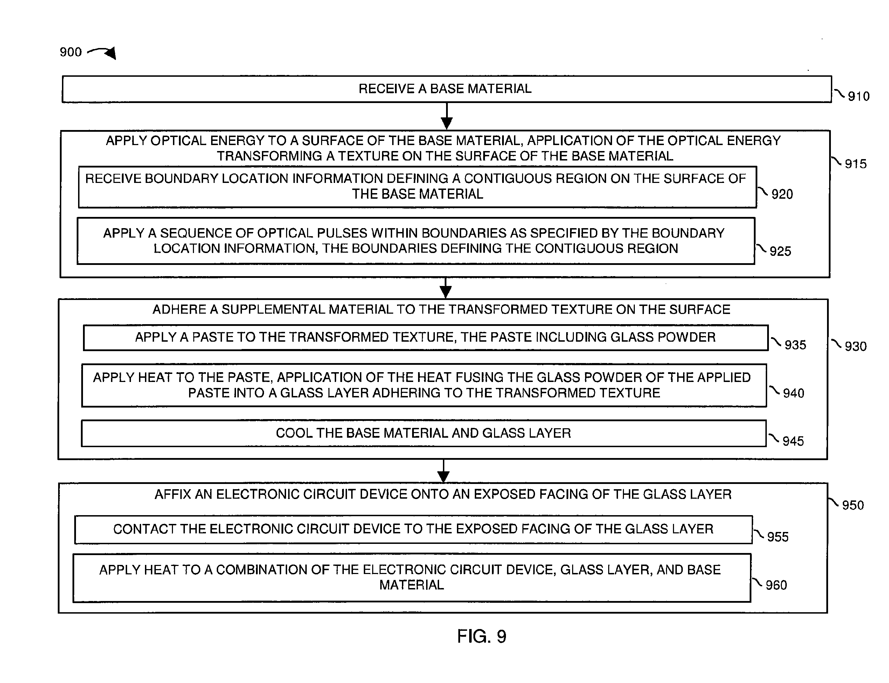

FIG. 9 is a flowchart 900 illustrating an example method according to embodiments. Note that there will be some overlap with respect to concepts as discussed above.

In processing block 910, a fabrication resource 110 (i.e., an assembler) receives base material 131.

In processing block 915, the fabrication resource 110 applies optical energy 111 to a surface of the base material 131. Application of the optical energy 111 I transforms an original texture of the base material 131 into transformed surface texture 122.

In processing block 920, the fabrication resource 110 receives location information 135 defining a contiguous region on the surface of the base material 131.

In processing block 925, the fabrication resource 110 applies optical energy 111 such as a sequence of optical pulses within boundaries as specified by the location information 135. As previously discussed, the location information 135 can define boundaries associated with the region 220.

In processing block 930, the fabrication resource 110 adheres a supplemental material to the transformed surface texture 122.

In processing block 935, the fabrication resource 110 applies material such as a paste to the transformed surface texture 122. As previously discussed, in one embodiment, the paste can include among other things, glass powder.

In processing block 940, the fabrication resource 110 applies heat to the paste. Application of the heat melts the glass powder. The resulting molten glass fuses together to form a glass layer adhering to the transformed surface texture 122.

In processing block 945, the fabrication resource 110 cools the base material 131 and corresponding glass layer.

In processing block 950, the fabrication resource 110 affixes an electronic circuit device onto an exposed facing of the glass layer.

In processing block 955, the fabrication resource 110 contacts the electronic circuit device to the exposed facing of the glass layer.

In processing block 960, the fabrication resource 110 applies heat to a combination of the electronic circuit device, glass layer, and base material 131.

Note again that techniques herein are well suited for surface preparation using optical energy. However, it should be noted that embodiments herein are not limited to use in such applications and that the techniques discussed herein are well suited for other applications as well.

While this invention has been particularly shown and described with references to preferred embodiments thereof, it will be understood by those skilled in the art that various changes in form and details may be made therein without departing from the spirit and scope of the present application as defined by the appended claims. Such variations are intended to be covered by the scope of this present application. As such, the foregoing description of embodiments of the present application is not intended to be limiting. Rather, any limitations to the invention are presented in the following claims.

## Claims

1. A method comprising:
receiving a base material;
applying optical energy to a surface of the base material, application of the optical energy transforming a texture on the surface of the base material; and
adhering a supplemental material to the transformed texture on the surface.

2. The method as in claim 1, wherein adhering the supplemental material to the transformed texture on the surface includes: i) applying a paste to the transformed texture, the paste including glass powder; and ii) applying heat to the paste, application of the heat fusing the glass powder of the applied paste into a glass layer adhering to the transformed texture; and iii) cooling the base material and glass layer; and
adhering an electronic circuit device onto an exposed facing of the glass layer.

3. The method as in claim 2, wherein the heat applied to the paste converts the glass powder into molten glass; and
wherein the transformed surface texture substantially prevents flow of the molten glass along the surface of the base material.

4. The method as in claim 3, wherein adhering the electronic circuit device onto the exposed facing of the glass layer includes: i) contacting the electronic circuit device to the exposed facing of the glass layer, and ii) applying heat to a combination of the electronic circuit device, glass layer, and base material;
wherein the heat applied to the paste converts the glass powder into molten glass; and
wherein the transformed surface texture allows flow of the molten glass along the surface of the base material..

5. The method as in claim 1, wherein applying the optical energy to the surface of the base material includes:
receiving boundary location information defining a contiguous region on the surface of the base material; and
applying a sequence of optical pulses within boundaries as specified by the boundary location information, the boundaries defining the contiguous region.

6. The method as in claim 5, wherein applying the sequence of optical pulses includes:
applying a first optical pulse to a first location within the contiguous region, the first optical pulse creating a first depression in the contiguous region;
applying a second optical pulse to a second location within the contiguous region, the second optical pulse creating a second depression in the contiguous region, the second depression at least partially overlapping with the first depression.

7. The method is in claim 1, wherein applying the optical energy includes:
scanning a laser beam in a first direction across the surface of the base material; and
scanning the laser beam in a second direction across the surface of the base material, the second direction substantially nonparallel with respect to the first direction.

8. The method as in claim 5, wherein adhering the supplemental material to the transformed texture on the surface includes: i) applying a paste to the transformed texture in the contiguous region defined by the boundary location information, the paste including glass powder; and ii) applying heat to the paste, application of the heat fusing the glass powder into a glass layer adhered to the transformed texture in the contiguous region; and iii) cooling the base material and glass layer;
contacting an electronic circuit device to the exposed facing of the glass layer; and
applying heat to a combination of the electronic circuit device, glass layer, and base material.

9. An assembly comprising:
a base material;
a texture on a surface of the base material transformed via application of optical energy; and
supplemental material adhered to the transformed texture on the surface.

10. The assembly as in claim 9, wherein the supplemental material adhered to the transformed texture on the surface is a paste applied to the transformed texture, the paste including glass powder, application of heat to the paste fusing the glass powder of the applied paste into a glass layer adhering to the transformed texture.

11. The assembly as in claim 10 further comprising:
an electronic circuit device adhered onto an exposed facing of the glass layer, the exposed facing opposite a facing of the glass layer adhered to the transformed texture.

12. The assembly as in claim 11, wherein the electronic circuit device is an integrated circuit device; and
wherein the base material is made of metal material.

13. The assembly as in claim 9, wherein the transformed texture resides within a contiguous region on the surface of the base material, the contiguous region defined by boundary location information.

14. The assembly as in claim 13, wherein the transformed texture in the contiguous region includes:
a first optically-generated depression in a first location within the contiguous region; and
a second optically-generated depression in second location within the contiguous region, the second optically-generated depression overlapping with the first optically-generated depression.

15. The assembly as in claim 9, wherein the transformed texture on the surface of the base material includes a pattern of optically-generated surface modifications;
wherein the pattern of optically-generated surface modifications on the transformed texture includes:
a first sequence of optically-generated modifications disposed in a first direction across the surface of the base material; and
a second sequence of optically-generated modifications disposed in a second direction across the surface of the base material, the second direction being substantially nonparallel with respect to the first direction.
